Europäisches Patentamt

European Patent Office

Office européen des brevets

(19)

(11) Publication number: **0 473 819 A1**

# EUROPEAN PATENT APPLICATION

(21) Application number: **90117025.8**

(22) Date of filing: **05.09.90**

(51) Int. Cl.⁵: **G11C 8/00**

(43) Date of publication of application:
**11.03.92 Bulletin 92/11**

(84) Designated Contracting States:
**DE FR GB**

(71) Applicant: **International Business Machines Corporation**
**Old Orchard Road**
**Armonk, N.Y. 10504(US)**

(72) Inventor: **Loehlein, Wolfdieter**
**Goldregenstrasse 2**
**W-7033 Herrenberg-Gültstein(DE)**
Inventor: **Wagner, Otto Martin**
**Buchenweg 36/1**
**W-7031 Altdorf(DE)**

(74) Representative: **Jost, Ottokarl, Dipl.-Ing.**
**IBM Deutschland GmbH Patentwesen und Urheberrecht Schönaicher Strasse 220**
**W-7030 Böblingen(DE)**

(54) **Multiport memory cell.**

(57) A memory cell is disclosed which contains two word lines (WLA, WLB) as well as two bit lines (BLA, BLB). Each of the word lines (WLA, WLB) can be separately addressed from a different decoder (50, 52) and hence the cell can be read by either one of two input/output devices.*)The memory cell is made of four n-type FETs (T3, T4, T5, T6) and four p-type FETs (T1, T2, T7, T8).

FIG.1

\*) In a write mode a multiplexer selects both word lines (WLA and WLB.

Field of the Invention

The invention relates to a multi-port memory cell containing two ports for reading the contents of the cell and one port for writing into the cell. The cell is suitable for incorporation into VLSI memories.

Prior Art

The so-called "6-device cell", first described by J.S. SCHMIDT in "Integrated MOS Random-access memory", Solid State Design, 21-25 (1965), forms the basis upon which subsequent memory cells made of field effect transistors have been designed. As the complexity of VLSI design has increased, so has the need arisen for cells to be able to be read by more than one device. A number of circuit designs have been developed to enable this function. Examples of these are given in US-A4768172 (SASAKI), "Multi-emitter merged transistor three-port array cell", IBM Technical Disclosure Bulletin, vol 28, nr 11, April 1986, pp 5063-5064 or in "Dense Multi-port SRAM Cell" by R.CLEMEN et al, IBM Technical Disclosure Bulletin, vol 32, nr 104, March 1990, pp 176-187. Each of these cell designs requires a relatively large number of transistors, even for a three-port cell, as well as having separate bit lines for writing data into the cell and reading data out of the cell. They are therefore costly to implement as well as requiring large amounts of chip space.

One method of overcoming some of these problems is the design disclosed in "Dense Multi-port cell scheme" by LOEHLEIN et al, IBM Technical Disclosure Bulletin, vol 30, nr 7, December 1987. In this publication, a circuit is disclosed which comprises a comparator to check whether two or more port addresses access the same cell at the same time and, if so, inhibiting all but one access. Whilst this circuit makes use of a cell with a single word line (unlike the other cited prior art), it still requires extra logic to construct the comparator.

An article by LOEHLEIN et al "Combined Single /Dual port array approach with 6-device cell", IBM Technical Disclosure Bulletin, vol. 31 (1), June 1988, pp. 291 teaches a cell design wnich comprises two word lines. One of these word lines is used for writing the contents of the cell, whilst the other is used for reading. It is not possible to use both word lines independently at the same time for reading.

Summary of the Invention

The invention offers an improvement over the state of the art by disclosing a memory cell which can be directly read by two devices at the same time using two different ports and which requires only six transistors for its construction. The cell uses the same word lines for both reading and writing. This is achieved by connecting the word lines to a multiplexer. On reading the cell, each of the read ports is connected to a different word line. However, on writing, the write port is connected to both word lines to allow the contents of the cell to be varied. The contents of the cell are read by comparing the change of the potential on the bit line with a reference potential. This allows VLSI circuits to be much simpler in design and each memory cell to occupy less space, saving both production costs and improving yield.

Brief Description of the Figures

Fig. 1    shows the basic memory cell including the word lines, bit lines and sense amplifiers.

Fig. 2    shows the external circuitry required to operate the memory cell.

Fig. 3    shows the timing diagram for the operation of the cell.

Detailed Description

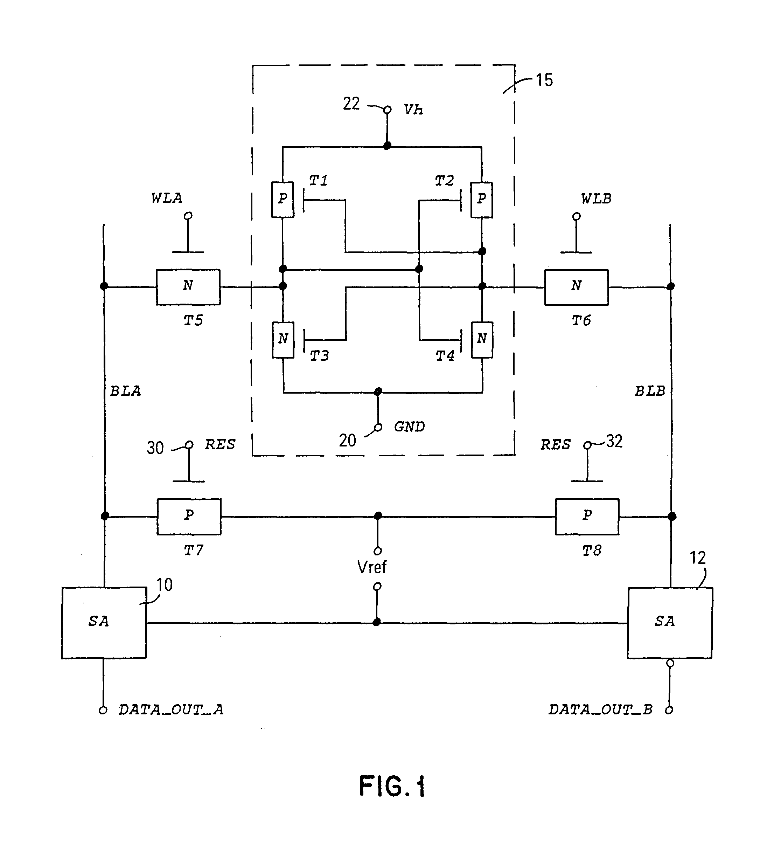

The basic memory cell is shown in Fig. 1. It consists of a flip-flop (15) formed by the p-type field effect transistors T1, T2 and the n-type field effect transistors T3, T4. The outputs of the flip-flop (15) are connected via n-type field effect transistors T5 and T6 to the bit lines BLA and BLB. The gates of transistors T5, T6 are formed by two different word lines WLA and WLB. The bit line BLA is connected to sense amplifiers 10. Sense amplifier 12, to which bit line BLB is connected, has an inverter connected to its output. The potential of the bit lines BLA and BLB is maintained at a reference voltage (Vref) through transistors T7 and T8.

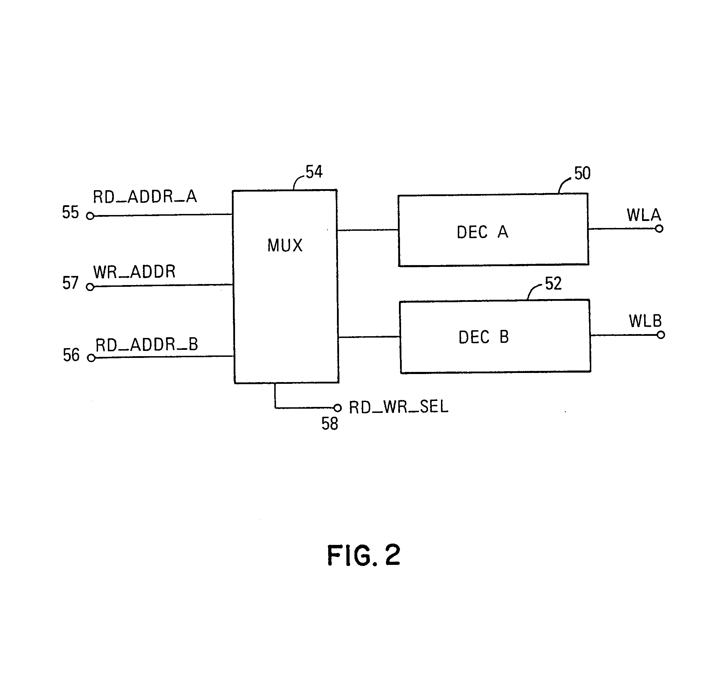

Fig. 2 shows the external circuitry required to operate the cell. Let us suppose that a processor wishes to read the contents of the memory cell. A signal RD_ADDR is generated which contains the address of the memory cell from which the data is to be extracted. On the figure, two lines 55, 56 are shown which are connected to a multiplexer 54. Each of these lines can carry a separate read signal RD_ADDR_A or RD_ADDR_B at the same time and the multiplexer 54 sends these signals independently to address decoders 50 and 52 respectively which decode the addresses of the cells to be read. The word lines WLA or WLB of the addressed memory cell are triggered and the cell's contents are read. The requests for reading may be addressed either to the same memory cell or to different memory cells since read operations operate independently of each other.

Suppose now that the processor wishes to write data into the cell. It generates a write address signal WR__ADDR on line 57 which is received by the multiplexer 54 and then passed to both decoders 50 and 52. Since the decoders 50, 52 decode the same signal (WR__ADDR) both word lines WLA and WLB of the same addressed cell become high and so the contents of the cell can be overwritten by changing the voltages on the bit lines BLA and BLB using well-known methods.

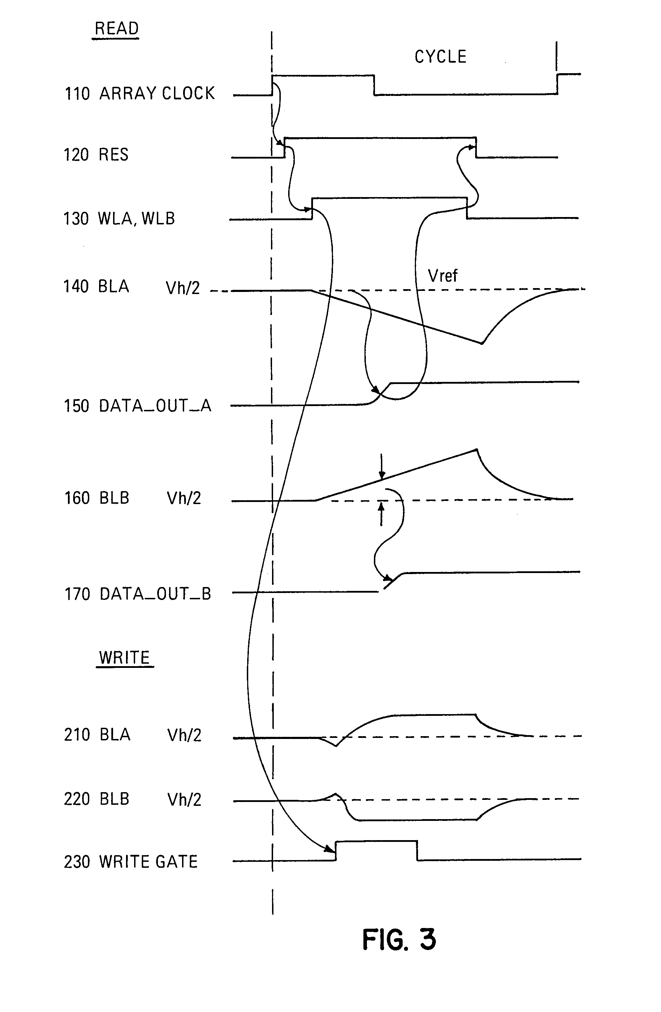

The operation of the cell can be understood by considering the timing diagram of Fig. 3. The Read operation will be first considered. The leading edge of the array clock (line 110) triggers the restore (RES) signal (line 120) which isolates Vref from bit lines BLA, BLB via p-type FETs T7 and T8. In the meantime the address signals RD__ADDR__A and/or RD__ADDR__B are stable and the decoding starts. After the decoding of the addresses is completed in the decoders 50 and 52, the word line can be triggered a specific time after the RES signal has been shut off (line 130). For the purposes of the explanation, it is assumed that the stored information is such that the common node of transistors T5, T1 and T3 is at 0 volts and hence the opposite node of transistors T2, T4 and T6 is at Vh. In this case, if WLA rises, transistor T5 is turned on and discharges the bit line BLA capacitance (line 140). The differential signal (Vref-Vbla, where Vbla is the potential on bit line BLA) is amplified through sense amplifier 10 and a data out signal DATA__OUT__A representative of the cell contents is generated (line 150). The reference potential Vref can be conveniently set at Vh/2.

The same process is happening at the other port. Since the act of reading out the contents of a cell through one bit line does not affect the act of reading out the contents of the same cell through the other bit line, no distinction is made about whether the same cell or another cell on the same bit line is being read in this example. When transistor T6 is switched on by word line WLB being triggered, the voltage on the bit line BLB rises from the reference potential (Vh/2) (line 160) and this is amplified by the sense amplifier 12. A positive output, DATA__OUT__B, representative of the cell contents is obtained through the inverting stage of the output of the sense amplifier 12.

As soon as the output is generated, the word lines can be shut off and a new RES signal is initiated (line 120) to bring the potentials of bit lines BLA and BLB back to the reference potential (Vh/2) (lines 140 and 160).

In a write operation, both the word lines WLA and WLB of one cell are connected together. This is achieved by sending the appropriate RD__WR__SEL signal to the multiplexer 54. The front end timing (lines 110, 120 and 130) to select the address of the cell is identical to the read operation. The write address signal WR__ADDR triggers a write gate (line 230) which pulls either BLA or BLB to ground (indicating a logical 1 or 0). The opposite bit line is brought up to Vh (lines 210 and 220). The cell, if it is being overwritten, will then flip and the write gate can be shut off. The bit lines can then be returned to the reference potential Vref by switching off RES.

## Claims

1. Multi-port memory cell comprising a flip-flop (15); word lines (WLA, WLB); bit lines (BLA, BLB); word line address decoders (50, 52) to decode the address of the said cell; read ports (55, 56) to read the value of the said cell; and a write port (57) to write a value into the said cell

   characterised in that

   a multiplexer (54) is connected between the said word lines address decoders (50, 52) and the said read ports (55, 56) and said write (57) ports.

2. Multiport memory cell according to claim 1 characterised in that

   said multiplexer (54) is controlled by a read or write select signal (RD__WR__SEL).

3. Multiport memory cell according to claims 1 or 2 further characterised in that

   a reference potential (Vref) is connected to the bit lines (BLA, BLB).

4. Multi-port memory cell according to claim 3 characterised in that

   the said reference potential (Vref) is connected to the said bit lines (BLA, BLB) through first p-type field effect transistors (T7, T8).

5. Multi-port memory cell according to claim 3 characterised in that

   a sense amplifier (10, 12) is connected to each of the said bit lines (BLA, BLB) and to the said reference potential (Vref).

6. Multi-port memory cell according to claim 1 characterised in that

the said flip-flop (15) is connected to the said bit lines (BLA, BLB) through first n-type field effect transistors (T5, T6)

and that each gate of the said first n-type field effect transistors (T5, T6) is connected to one of the said word lines (WLA, WLB).

7.  Multi-port memory cell according to claim 1 characterised in that

the said flip-flop (15) consists of a second and a third p-type field effect transistors (T1, T2) and a second and a third n-type transistors (T3, T4).

8.  Multi-port memory cell according to claim 7 characterised in that

the source or drain of both of the said second and third p-type field effect transistors (T1,

T2) are connected together and to a potential (22);

the source or drain of both of the said second and third n-type field effect transistors (T3, T4) are connected together and to ground (20);

the source or drain of the second said p-type field effect transistor (T1) is connected to one of the outputs of the said flip-flop (15) and to the source of drain of said second n-type transistors (T3) and forms the gates of the said third p-type transistor (T2) and the said third n-type field effect transistors (T4) and

the source or drain of the said third p-type field effect transistor (T2) is connected to the other of the outputs of the said flip-flop (15) and to the source or drain of said third n-type transistor (T4) and forms the gates of the said second said p-type transistor (T1) and the said second n-type field effect transistors (T3).

9.  Multi-port memory cell as described in any of the above claims characterised in that there are

two of said bit lines (BLA, BLB);

two of said word lines (WLA, WLB);

two of said sense amplifiers (10, 12), one of which has an inverting output.

10. Method of reading the contents of the multi-port memory cell as described in any of claims 1 to 9 comprising

a first step of passing the address of the said memory cell (RD_ADDR_A, RD_ADDR_B) from which the data is to be read to an address decoder (50, 52);

a second step of isolating the source of the said reference voltage (Vref) from the said bit lines (BLA, BLB) by applying a signal (RES) to the gate of the said first p-type transistors (T7, T8);

a fourth step of decoding the cell address (RD_ADDR_A, RD_ADDR_B) in the said address decoder (50, 52) to raise the voltage on the said word lines (WLA, WLB) to switch on the said first n-type field effect transistors (T5, T6);

a fifth step of detecting in the said sense amplifiers (10, 12) the change of voltage on the said bit lines (BLA, BLB) from the reference voltage (Vref) and

a sixth step of outputting from the said sense amplifiers (10, 12) a signal (DATA_OUT_A, DATA_OUT_B) representing the contents of the said memory cell.

11. A method of reading the contents of the multi-port memory cell according to claim 10 characterised in that

the voltage on more than one of said word lines (WLA, WLB) connected to the same said memory cell can be raised at the same time to read the contents of the same said memory cell through different of said sense amplifiers (10, 12).

12. A method of rewriting the contents of the multi-port memory cell as described in any of claims 1 to 9 comprising

a first step of passing the address of said memory cell (WR_ADDR) whose contents have to be rewritten to a multiplexer (54);

a second step of passing the said address (WR_ADDR) to both of said address decoders (50, 52) connected to both of said word lines (WLA, WLB) connected to the said memory cell whose contents have to be rewritten;

a third step of isolating the source of the said reference voltage (Vref) from the said bit lines (BLA, BLB) by applying a signal (RES) to the gate of the said third p-type transistors (T7, T8);

a fourth step of decoding the cell address (WR__ADDR) in the said address decoder (50, 52) to raise the voltage on the said word lines (WLA, WLB) to switch on the said third n-type field effect transistors (T5, T6);

a fifth step of raising the voltage on the said bit lines (BLA, BLB) to force the said flip-flop (15) to acquire the desired value.

13. A method of writing the contents of the memory cell according to claim 12 characterised in that

the said multiplexer (54) is controlled by a read or write select signal (RD__WR__SEL).

FIG.1

FIG. 2

READ

CYCLE

110 ARRAY CLOCK

120 RES

130 WLA, WLB

140 BLA    Vh/2

Vref

150 DATA_OUT_A

160 BLB    Vh/2

170 DATA_OUT_B

WRITE

210 BLA    Vh/2

220 BLB    Vh/2

230 WRITE GATE

FIG. 3

European
Patent Office

EUROPEAN SEARCH
REPORT

Application Number

EP 90 11 7025

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 180 467 (AMD)<br>* Page 7, lines 7-17; page 8, line 5 - page 9, line 7; page 10, lines 17-33; page 15, line 31 - page 16, line 21; figures 1,2A,3 * | 1,2 | G 11 C 8/00 |
| A | | 5-13 | |
| | – – – | | |
| A | WO-A-8 809 035 (ANALOG DEVICES)<br>* Page 6, line 9 - page 8, line 18; figure 1 * | 1,2 | |
| | – – – | | |
| X | NL-A-8 800 084 (PHILIPS)<br>* Page 4, line 34 - page 5, line 34; figure 2 * | 3,4 | |
| | – – – – – | | |

TECHNICAL FIELDS
SEARCHED (Int. Cl.5)

G 11 C 8
G 11 C 7

The present search report has been drawn up for all claims

| Place of search | Date of completion of search | Examiner |
|---|---|---|
| The Hague | 03 June 91 | LINDQUIST J.W. |

CATEGORY OF CITED DOCUMENTS

X : particularly relevant if taken alone
Y : particularly relevant if combined with another
    document of the same catagory
A : technological background
O : non-written disclosure
P : intermediate document
T : theory or principle underlying the invention

E : earlier patent document, but published on, or after
    the filing date
D : document cited in the application
L : document cited for other reasons

& : member of the same patent family, corresponding
    document